# EUROPEAN PATENT APPLICATION

(11) **EP 1 198 164 A1**
(43) Date of publication of application: **17.04.2002**
(21) Application number: 00610102.6
(22) Date of filing: 11.10.2000
(51) Int. Cl.: H05K 9/00, H05K 3/12

(54) **A method of making a gasket on a PCB and a PCB.**

(71) Applicant: Telefonaktiebolaget L M Ericsson (Publ), 126 25 Stockholm (SE)
(72) Inventor: Bygdö, Hakan, 226 54 Lund (SE); Wilson, Andreas, 212 22 Malmö (SE)
(74) Representative: Boesen, Johnny Peder

(57) **Abstract**

The invention relates to: A method of making a gasket (1) on a PCB (Printed Circuit Board) (2) and a PCB comprising a gasket. The object of the present invention is to provide a method of making a high quality gasket that may be conveniently customized to individual needs and which is easily integrated in a normal assembly process. The problem is solved in that the gasket (1) is made by screen printing techniques. This method has the advantage of using a technique that is already commonly used in an electronics assembly environment, and which method may implement relatively complex patterns with a relatively high precision in the layout of feature dimensions and which is relatively economic in use. The invention may e.g. be used for making customized gaskets for EMI shields on a PCB.

## Description

### Technical Field of the Invention:

The invention relates to: A method of making a gasket on a PCB (Printed Circuit Board).

The invention furthermore relates to: A printed circuit board comprising a gasket.

### Description of Related Art:

The following account of the prior art relates to one of the areas of application of the present invention, the assembly of a PCB and a shielding frame or case. A gasket is often used to ensure a good electrical contact between the frame or case and a ground plane or ground conductor(s) on the PCB. A good electrical contact between PCB and casing or shield is of particular importance in case that certain components or parts of the PCB or the entire board has to be protected against electromagnetic interference (EMI) from other sources, or that the electromagnetic radiation from the parts in question must be contained.

In the prior art several gaskets (WO-A-97/12 505) or gasket assemblies (WO-A-99/51 074, WO-A-99/33 328) or EM-shield assemblies including a gasket (WO-A-98/49 880, US-A-5,717,577) are disclosed.

The gaskets used today are often separate components, typically contributing to the complexity of the overall production process by introducing yet another supplier, making the logistics and quality control more complex.

Often a metallic gasket is used, which creates galvanic problems in a humid environment. To solve that problem the frame must be specially processed in the area of contact with the gasket, which also contributes to the complexity of the overall production process.

Another type of gasket used today is arranged on the frame. A drawback of this solution is that a relatively high pressure is needed to compress the gasket evenly in the total frame/PCB contact area. This problem is especially relevant in thin (sub mm) state of the art PCBs, in which case the pressure of the frame results in bending of the board so that components mounted on the board and their electrical connections are mechanically stressed, ultimately leading to instances of loss of electrical contact ("ball off").

### Summary:

A problem of the prior art involving gaskets that are individual parts (e.g. spring gaskets or rubber gaskets covered with a metallic sheet) is that they have to be customized to each individual application requiring various amounts of adjusting work to be done to the PCB and/or the casing, and that they complicate the logistics and QA.

A problem of the prior art involving gaskets that are arranged on a frame is that the joining of the frame and the PCB requires a relatively high pressure causing mechanical stress on the board and possibly damage to the electrical contacts on the board, which decreases reliability.

The object of the present invention is to provide a method of making a high quality gasket that may be conveniently customized to individual needs and which is easily integrated in a normal assembly process.

This is achieved according to the invention in that the gasket is made by screen printing techniques.

An advantage of the method according to the invention is that it makes use of a technique for making a gasket on a PCB that is already commonly used in an electronics assembly environment for other parts of the assembly process (e.g. the application of soldering paste), and which method is applicable for mass production, may implement relatively complex patterns with a relatively high precision in the layout of feature dimensions and which is relatively economical in use. The outer surface of a gasket according to the invention has a high degree of evenness resulting in a high quality closure, thus providing a good EMI shield. The 3D vision systems that are commonly used for the control of screen printed bodies are well suited for controlling the quality of the gasket. The integration of the production of the gasket in the assembly process gives a simpler production process by reducing the dependence on suppliers.

When the gasket is adapted to be used between a PCB and a frame, it is ensured that a method that is flexible and well suited for integration in an ordinary component assembly process is provided, and that an accurate and customized sealing between PCB and frame is provided.

When the gasket paste is applied in individual, spaced portions as opposed to a continuous pattern, it is ensured that a relatively lower pressure is sufficient to apply the frame to the PCB, which reduces the risk of causing mechanical damage to the board, thus enhancing mechanical and electronic reliability by improving the proper electrical contact between board and frame by means of the gasket and by reducing damage to the electrical contacts of the board.

When the application of solder paste and gasket paste, respectively, to said PCB is performed in two subsequent steps using the same screen plate, it is ensured that a simple and economical method is provided.

In a preferred embodiment it comprises the steps of
1.1. creating a screen plate for applying solder paste and gasket paste to the PCB
1.2. creating gauges G1 and G2 for covering the gasket pattern and the soldering pattern, respectively
1.3. placing the screen plate on the PCB
1.4. covering the screen plate with gauge G1 screening the gasket pattern
1.5. printing the solder paste on the PCB
1.6. removing the gauge G1 from the screen plate
1.7. covering the screen plate with gauge G2 screening the soldering pattern
1.8. printing the gasket paste on the PCB
1.9. curing the gasket paste
1.10. removing the gauge G2 from the screen plate and removing the screen plate from the PCB. An advantage of this is that the same screen plate is used for the application of the solder paste and the gasket paste so that the movement of the screen plate between these processing steps is avoided. The gauges used for covering the screen plate are independent of possible changes to the layout of the PCB. Plastic gauges, which have a longer product lifetime (as opposed to stainless steel or Nickel plated ones) and are economical, may be used.

In a preferred embodiment the gasket is formed in a direction perpendicular to the PCB by using two or more gauges G2a and G2b for the application of gasket paste thereby ensuring that the gasket may be formed in a 3^{rd} dimension according to special needs, e.g. to optimize the sealing or contacting properties of the gasket or adapt it to a certain form of a frame or the like.

In a preferred embodiment it comprises the steps of
2.1. creating a screen plate for applying solder paste
2.2. creating a screen plate for applying gasket paste with the following pattern:
   through holes for gasket paste
   hollows for solder paste protection
2.3. placing the solder paste screen plate on the PCB
2.4. applying the solder paste to the PCB
2.5. removing the solder screen plate
2.6. placing the gasket screen plate on the PCB, the hollows on the gasket protect the solder paste from the gasket paste and from any form of mechanical deformations
2.7. applying the gasket paste to the PCB
2.8. removing the gasket screen plate
2.9. heating the PCB to melt solder paste and start the curing of the gasket paste. An advantage of this is that no special or new production equipment is necessary in the sense that the production equipment for applying gasket paste is a mere replication of the corresponding equipment for applying solder paste. The time needed for the application of gasket paste is of an order smaller than or comparable to the time needed for applying solder paste. In other words the application of gasket paste does not slow down the flow of the assembly line. A further advantage of the embodiment described above is that the screen plate for applying gasket paste may be used again and again in cases where the layout of components and/or electrical connections on the PCB is changed. This scenario is e.g. relevant during the development of a product where revisions of the layout may be needed a number of times, and in cases where the size of the PCB is limited by more or less fixed outer restrictions (such as in the case of a cellular telephone).

When the curing is done with UV light, an increased control of the curing process is ensured, including that the shape of the gasket is kept to a higher degree, which is especially important for HF EMI shielding.

When the curing is done with heat, it is ensured that a cost-effective and well-working solution that is fast and environmentally controllable is provided. It is further attractive from an assembly line flow point of view, since no extra steps for curing must be included (because the same oven may be used for curing and soldering).

A printed circuit board comprising a gasket is furthermore provided by the present invention. When said gasket is made by screen printing techniques, the advantages outlined above for the independent method claim are achieved.

### Brief Description of the Drawings:

The invention will be explained more fully below in connection with a preferred embodiment and with reference to the drawings, in which:
fig. 1 shows the steps involved in the making of a gasket according to an embodiment of the invention,
figs. 2.a-2.c show some of the process steps for providing a PCB with solder dots and a gasket according to the invention,
fig. 3 shows the steps involved in the making of a gasket according to a preferred embodiment of the invention,
figs. 4.a-4.c show some of the process steps for providing a PCB with solder dots and a gasket according to a preferred embodiment of the invention,
figs. 5.a and 5.b illustrate the control of the 3rd dimension of a gasket according to the invention, and
fig. 6 shows the application of gasket paste in separate islands.

The figures are schematic and simplified for clarity, and they just show details which are essential to the understanding of the invention, while other details are left out. Throughout, the same reference numerals are used for identical or corresponding parts.

### Detailed Description of Embodiments:

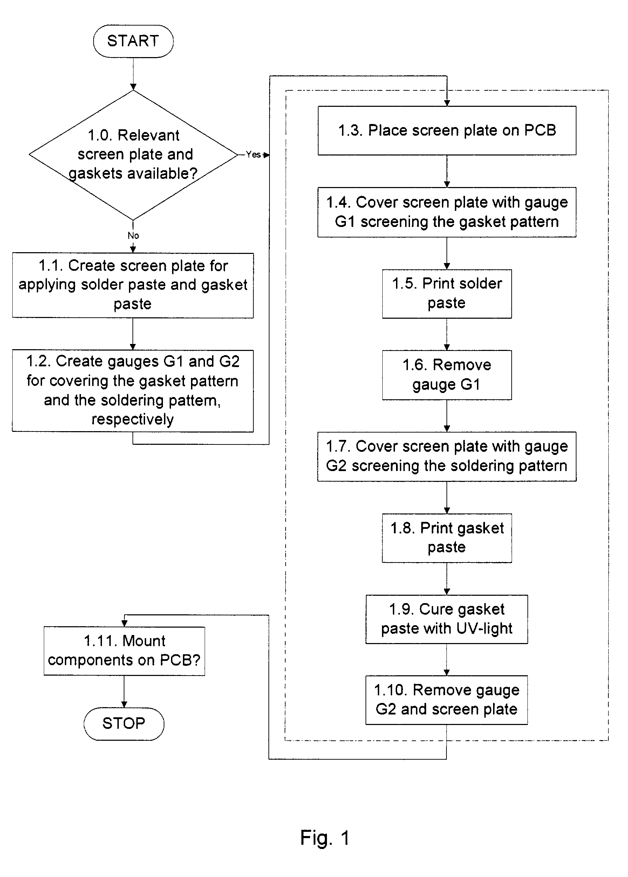

Fig. 1 shows the steps involved in the making of a gasket according to an embodiment of the invention.

These steps are:
1.0. Are the relevant screen plate and gaskets available? If yes, go to step 1.3. If no, continue in step 1.1.
1.1. Creating a screen plate for applying solder paste and gasket paste to the PCB.
1.2. Creating gauges G1 and G2 for covering the gasket pattern and the soldering pattern, respectively.
1.3. Placing the screen plate on the PCB.
1.4. Covering the screen plate with gauge G1 screening the gasket pattern.
1.5. Printing the solder paste on the PCB.
1.6. Removing the gauge G1 from the screen plate.
1.7. Covering the screen plate with gauge G2 screening the soldering pattern.
1.8. Printing the gasket paste on the PCB.
1.9. Curing the gasket paste with UV light.
1.10. Removing the gauge G2 and the screen plate from the PCB.
1.11. Mounting the components on the PCB. (This step is not part of the process of making a gasket according to the invention).

It should be mentioned that although the curing of the gasket paste in the embodiment above is done by means of UV light, it might just as well be done by means of any other known method. Such other method of curing the gasket paste might require one or more additional steps or the rearrangement of the order of the steps.

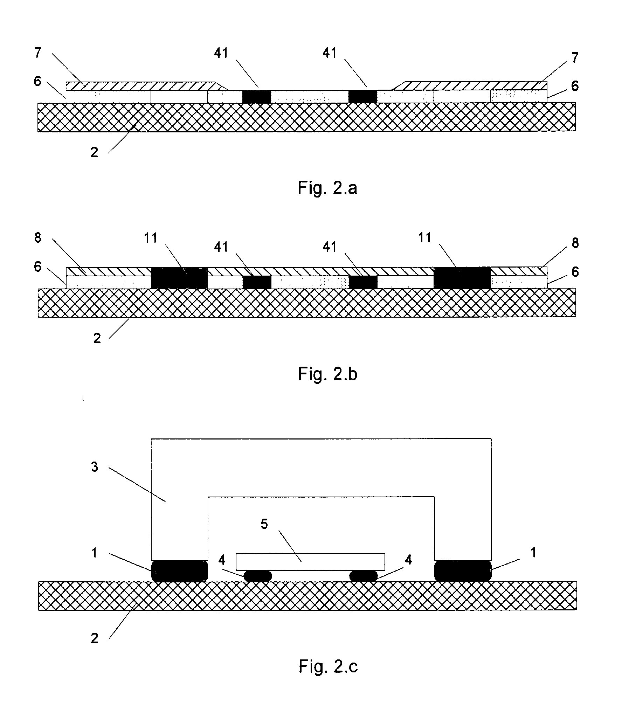

Figs. 2.a-2.c show some of the process steps for providing a PCB with solder dots and a gasket according to the invention.

In fig. 2.a a screen plate 6 according to the invention for applying gasket paste, and solder paste has been placed on a PCB 2. A gauge 7 (G1) for covering the gasket pattern has been placed on the screen plate 6 and solder paste 41 has been applied.

In fig. 2.b the gauge 7 (G1) for covering the gasket pattern has been removed, and the gauge 8 (G2) for covering the solder pattern has been placed on the screen plate 6, and gasket paste 11 has been applied.

In fig. 2.c the gauge 8 (G2) for covering the gasket pattern and the screen plate 6 has been removed. The gasket paste (11 in fig. 2.b) has been cured to a gasket 1, and a component 5 has been soldered to the PCB 2 by heating the solder paste (41 in figs. 2.a and 2.b), as indicated by solder contacts 4. A frame 3 for EMI shielding the electronic component 5 has been mounted on the gasket 1 and PCB 2.

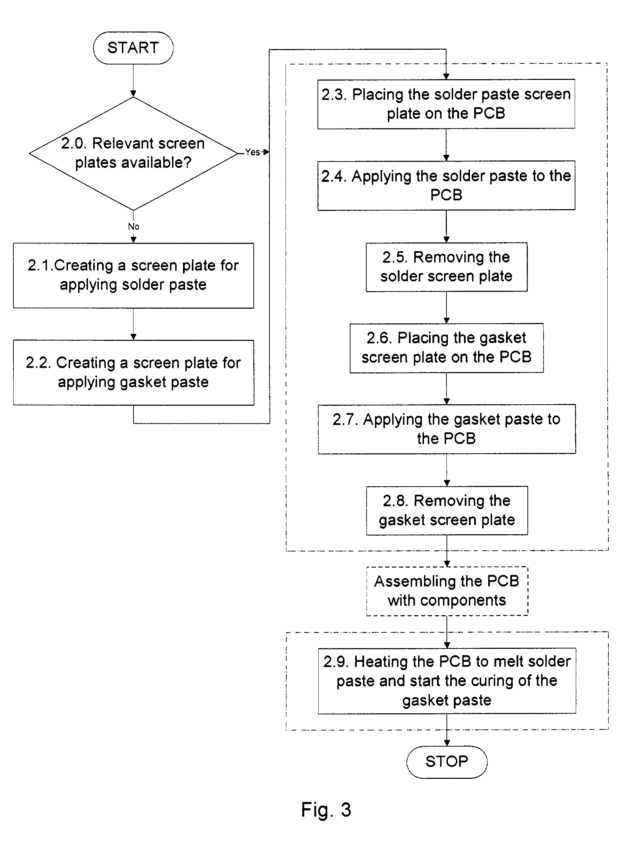

Fig. 3 shows the steps involved in the making of a gasket according to a preferred embodiment of the invention.

These steps are:
2.0. Are the relevant screen plates available? If yes, go to step 2.3. If no, continue in step 2.1.
2.1. Creating a screen plate for applying solder paste.
2.2. Creating a screen plate for applying gasket paste with the following pattern:
   Through holes for gasket paste.
   Hollows for solder paste protection.
2.3. Placing the solder paste screen plate on the PCB.
2.4. Applying the solder paste to the PCB.
2.5. Removing the solder screen plate.
2.6. Placing the gasket screen plate on the PCB, the hollows on the gasket protecting the solder paste from the gasket paste and from any form of mechanical deformations.
2.7. Applying the gasket paste to the PCB.
2.8. Removing the gasket screen plate.
   After step 2.8. assembling the PCB with components (i.e. the positioning of the components on the PCB, e.g. by a mounting robot) is performed.
2.9. Heating the PCB to melt solder paste and start the curing of the gasket paste.

It should be mentioned that although the curing of the gasket paste in the embodiment above is done by means of heating, it might just as well be done by means of any other known method. Such other method of curing the gasket paste might require one or more additional steps or the rearrangement of the order of the steps.

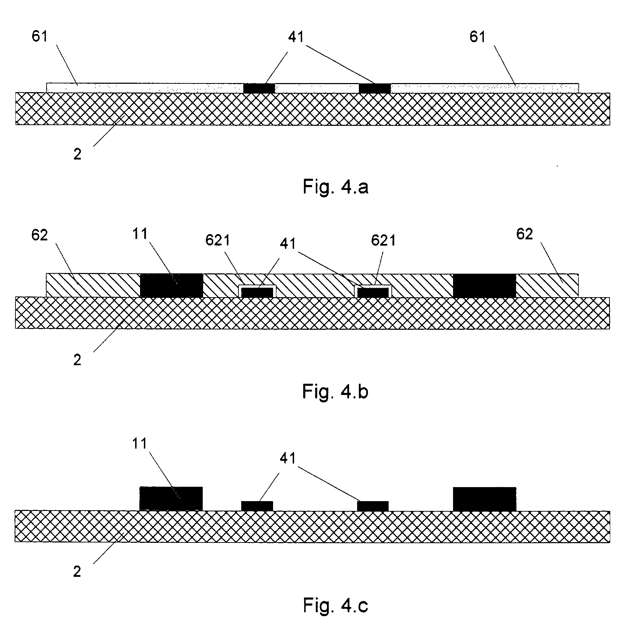

Figs. 4.a-4.c show some of the process steps for providing a PCB with solder dots and a gasket according to a preferred embodiment of the invention.

In fig. 4.a a screen plate 61 for applying solder paste has been placed on a PCB 2, and solder paste 41 has been applied.

In fig. 4.b the screen plate 61 for applying solder paste has been removed, and a screen plate 62 for applying gasket paste has been placed on the PCB 2, and gasket paste 11 has been applied. Hollows 621 in the screen plate 62 for applying gasket paste are shown on the side of the screen plate facing the PCB. These hollows 621 are formed in the screen plate 62 in accordance with the solder paste pattern on the screen plate 61 for applying solder paste in such a way that the hollows 621 protect the solder paste 41 when the screen plate 62 for applying gasket paste is placed correctly on the PCB.

Fig. 4.c shows the resulting solder paste 41 and gasket paste 11 patterns on the PCB 2 when the screen plate 62 for applying gasket paste has been removed.

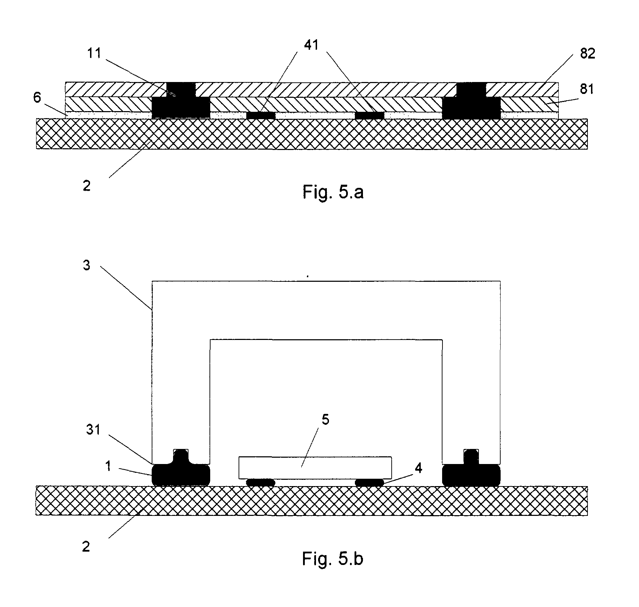

Figs. 5.a and 5.b illustrate the control of the 3rd dimension of a gasket according to the invention. The following refers to the method as illustrated in figs 1 and 2.

The 3rd dimension of the gasket (i.e. in the direction perpendicular to the PCB) may be controlled, leading to additional advantages. This may be done for example by using two or more gauges in the printing of the gasket paste as illustrated in figs. 5.a and 5.b.

Fig. 5.a shows a screen plate 6 for applying solder paste 41 and gasket paste 11 placed on a PCB 2. Solder paste 41 has been applied. Gauge 81 for applying gasket paste shielding the solder paste pattern has been placed on the screen plate 6 and gasket paste has been applied. Gauge 82 for applying gasket paste shielding the solder paste pattern has been placed on the gauge 81 and gasket paste has been applied.

In fig. 5.a, the two gauges 81 (G2a) and 82 (G2b) yield essentially the same gasket pattern, only the pattern of gauge 82 (G2b) exhibits a shrinked width compared to 81 (G2a). G2b is placed on top of G2a in such a way that the centre lines of the gasket patterns coincide, i.e. so that the width difference between the two patterns is distributed essentially equally to the two sides of the centre line. This allows a customization of the gasket in the 3^{rd} dimension that may be utilized to improve its performance, e.g. by forming a channel in the shield of corresponding shape. The centre line of gasket 82 may, however, also be positioned in other ways.

Other cross-sectional shapes than that illustrated in fig. 3 may be implemented, optionally using more gauges.

In fig. 5.b. a frame 3 has been assembled on the gasket 1 (resulting from a curing of the gasket paste pattern 11) in a pressing process forcing the frame to adapt the contours of the gasket. This contour 31 might, however, also be formed in the frame in advance, if appropriate. Component 5 has been assembled on the PCB 2, using the laid out soldering pattern (indicated by solder contacts 4) by appropriately heating the solder paste (41 in fig. 5.a).

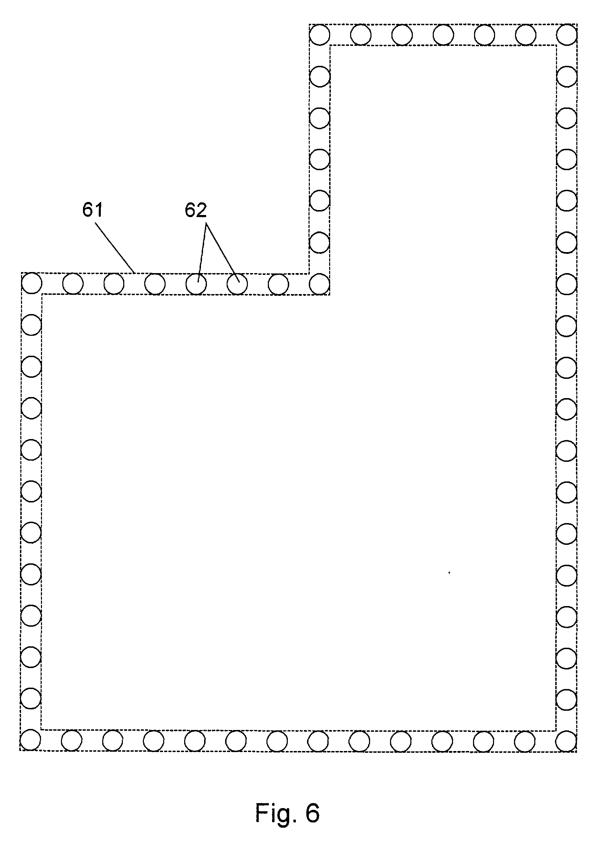

Fig. 6 illustrates the application of gasket paste in separate islands. To minimize the pressure that is needed to join (i.e. ensure a sufficient electrical contact) a frame with a PCB by means of a gasket and thus to minimize the risk of introducing mechanical faults in the PCB and its assembled components and electrical connections, the gasket paste may be applied in separate islands 62 in the overall outline 61 of the gasket. In a preferred embodiment the diameter of each island 62 is approximately equal to the distance between two adjacent islands. A preferred dimension is around 1 mm. The use of a 'dotted' gasket may reduce the required pressure to appropriately join the frame with the PCB by 50% or more.

Some preferred embodiments have been shown in the foregoing, but it should be stressed that the invention is not limited to these, but may be embodied in other ways within the subject-matter defined in the following claims. The method is not limited to making a gasket on a PCB but may just as well be used in connection with other substrates, such as ceramic substrates used for hybrid electronic circuits involving thick film or thin film techniques.

## Claims

1. A method of making a gasket (1) on a PCB (Printed Circuit Board) (2),
**characterized in that**
the gasket (1) is made by screen printing techniques.

2. A method according to claim 1,
**characterized in that**
the gasket (1) is adapted to be used between a PCB (2) and a frame (3).

3. A method according to claim 1 or 2,
**characterized in that**
the gasket paste (11) is applied in individual, spaced portions (62).

4. A method according to any one of claims 1-3,
**characterized in that**
the application of solder paste (41) and gasket paste (11), respectively, to said PCB (2) is performed in two subsequent steps using the same screen plate (6).

5. A method according to any one of claims 1-3,
**characterized in that**
it comprises the steps of
1.1. creating a screen plate (6) for applying solder paste (41) and gasket paste (11) to the PCB (2)
1.2. creating gauges G1 (7) and G2 (8) for covering the gasket pattern and the soldering pattern, respectively
1.3. placing the screen plate (6) on the PCB (2)
1.4. covering the screen plate (6) with gauge G1 (7) screening the gasket pattern
1.5. printing the solder paste (41) on the PCB (2)
1.6. removing the gauge G1 (7) from the screen plate (6)
1.7. covering the screen plate (6) with gauge G2 (8) screening the soldering pattern
1.8. printing the gasket paste (11) on the PCB (2)
1.9. curing the gasket paste (11)
1.10. removing the gauge G2 (8) from the screen plate (6) and removing the screen plate (6) from the PCB (2).

6. A method according to claim 5,
**characterized in that**
the gasket (1) is formed in a direction perpendicular to the PCB (2) by using two or more gauges G2a (81) and G2b (82) for the application of gasket paste (11).

7. A method according to any one of claims 1-3,
**characterized in that**
it comprises the steps of
2.1. creating a screen plate (61) for applying solder paste (41)
2.2. creating a screen plate (62) for applying gasket paste (11) with the following pattern:
through holes for gasket paste
hollows (621) for solder paste protection
2.3. placing the solder paste screen plate (61) on the PCB (2)
2.4. applying the solder paste (41) to the PCB (2)
2.5. removing the solder screen plate (61)
2.6. placing the gasket screen plate (62) on the PCB (2), the hollows (621) on the gasket protecting the solder paste (41) from the gasket paste (11) and from any form of mechanical deformations
2.7. applying the gasket paste (11) to the PCB (2)
2.8. removing the gasket screen plate (62)
2.9. heating the PCB (2) to melt solder paste (41) and start the curing of the gasket paste (11).

8. A method according to any one of claims 5-7,
**characterized in that**
the curing is done with UV light.

9. A method according to any one of claims 5-7,
**characterized in that**
the curing is done with heat.

10. A printed circuit board (2) comprising a gasket (1),
**characterized in that**
said gasket (1) is made by screen printing techniques.
